Europäisches Patentamt

European Patent Office

Office européen des brevets

(11) Numéro de publication: **0 216 703 B1**

# FASCICULE DE BREVET EUROPEEN

(45) Date de publication de fascicule du brevet:
**22.01.92**

(51) Int. Cl.⁵: **C03C 17/23**, H01L 31/02,
H01L 31/18

(21) Numéro de dépôt: **86402059.9**

(22) Date de dépôt: **19.09.86**

(54) **Substrat conducteur et transparent pour élément photoélectrique.**

(30) Priorité: **20.09.85 JP 208363/85**

(43) Date de publication de la demande:
**01.04.87 Bulletin 87/14**

(45) Mention de la délivrance du brevet:
**22.01.92 Bulletin 92/04**

(84) Etats contractants désignés:
**AT BE CH DE FR GB IT LI LU NL SE**

(56) Documents cités:
**EP-A- 0 112 780**
**EP-A- 0 121 459**

**SOLAR CELLS vol.13, no. 3, janvier 1985, pages 301-307, Lausanne, CH; K.Kim et al.: "Annealing Effect of SnO2 Films prepared by Chemical Vapor Deposition: Evidence of Chlorine Removal by Auger Electron Spectroscopy and Rutherford Back-Scattering Spectrometry Studies"**

**JOURNAL OF THE AMERICAN CERAMIC SOCIETY vol. 58, 1975, pages 23-25, Columbus, Ohio, US; M.KIM et al.: "Compositions and cnductivity of tin oxide films prepared by**
pyrohydrolytic decomposition of tin (IV) compounds"

(73) Titulaire: **SAINT-GOBAIN VITRAGE INTERNATIONAL**
**18, avenue d'Alsace**
**F-92400 Courbevoie(FR)**

(72) Inventeur: **Hirata, Masahiro**
**21-1-320, Ohata-Cho**
**Takatsuki-Shi Osaka(JP)**
Inventeur: **Misonou, Masao**
**6-1-104, Damjo-Cho 6-Chome**
**Nishinomiya-Shi Hyog(JP)**
Inventeur: **Kawahara, Hideo**
**8-3-205, Minami Sakurazuka 2-Chome**
**Toyonaka-Shi Osaka(JP)**

(74) Mandataire: **Leconte, Jean-Gérard et al**
**Saint-Gobain Recherche 39, Ouai Lucien Lefranc**
**F-93304 Aubervilliers Cedex(FR)**

## Description

La présente invention concerne un substrat à la fois conducteur et transparent pour élément photoélectrique constitué par exemple d'une plaque de verre revêtue d'une couche conductrice et transparente à base d'oxyde d'étain, cet élément étant utilisable notamment dans des cellules ou piles solaires.

Il existe des piles solaires ayant comme élément photoélectrique un substrat conducteur transparent revêtu de silicium amorphe a-Si et muni d'électrodes en aluminium. De telles piles solaires ont un faible taux de conversion photoélectrique et pour l'améliorer on a cherché à rendre le substrat le plus conducteur possible en dopant la couche d'oxyde d'étain à l'aide de fluor.

On a ainsi obtenu une amélioration du rendement des piles solaires pour des épaisseurs de couches d'oxyde d'étain qui étaient classiquement inférieures à 0,6 micron.

Pour encore abaisser la résistance électrique des couches d'oxyde d'étain dopées au fluor, on a tout logiquement augmenté leur épaisseur, mais il est apparu que le taux de conversion photoélectrique au lieu de s'améliorer encore, au contraire diminuait à partir d'une épaisseur de couche conductrice de l'ordre de 0,7 micron.

La présente invention vise à résoudre ce problème et à fournir un substrat transparent, notamment en verre, revêtu d'une couche à base d'oxyde d'étain, utilisable en tant qu'élément photoélectrique en particulier dans des piles solaires, et permettant d'atteindre des taux de conversion photoélectrique élevés, supérieurs à ceux obtenus avec des éléments photoélectriques dont la couche d'oxyde d'étain est dopée au fluor.

Pour cela, elle propose un substrat transparent constitué d'un support, notamment en verre, revêtu d'une couche conductrice et transparente à base d'oxyde d'étain obtenue par décomposition thermique et oxydation au contact du support porté à haute température, d'un composé d'étain contenant du chlore mais aucun autre halogène, ou d'un composé d'étain sans chlore mais auquel on ajoute en appoint un autre composé contenant du chlore tel que HCl, cette couche conductrice, à base d'oxyde d'étain ayant une épaisseur au moins égale à 0,7 micron.

Les composés d'étain contenant du chlore, et aucun autre halogène que le chlore, sont toutefois préférables aux composés d'étain sans chlore auxquels on ajoute en appoint un composé contenant du chlore tel HCl.

Comme composés d'étain utilisables et contenant du chlore, on peut citer :
$C_4H_9SnCl_3$
$SnCl_4$

$(CH_3)_2SnCl_2$ , etc...

Comme composés d'étain ne contenant pas de chlore, mais auxquels on peut adjoindre un autre composé contenant du chlore, on peut citer :
$(CH_{2n+1})_4Sn$ avec n = 1, 2, 3 ou 4
$(CH_3)_2SnH_2$ , $(C_4H_9)_3SnH$
$(CH_4H_9)_2Sn(COOCH_3)_2$ , etc

Pour mettre ces composés d'étain en contact avec le support chauffé, et obtenir leur décomposition et leur oxydation, on peut utiliser la méthode C.V.D. (Chemical Vapor Deposition) consistant à mettre une vapeur de ces composés en contact avec le support chauffé, la méthode de pyrolyse de solution consistant à pulvériser une solution de ces composés sur le support chauffé, ou toute autre méthode, en particulier la méthode de pyrolyse de poudre.

Parmi toutes ces méthodes, on utilise de préférence la méthode C.V.D., avantageuse en particulier pour sa souplesse d'utilisation et la qualité du dépôt obtenu. Le support transparent, notamment le verre, est alors chauffé à une température de l'ordre de 400 à 600°C.

L'épaisseur prévue de la couche conductrice d'oxyde d'étain est au moins de 0,7 micron, mais de préférence, pour améliorer encore le taux de conversion photoélectrique, elle est de l'ordre de 0,8 à 1,2 microns.

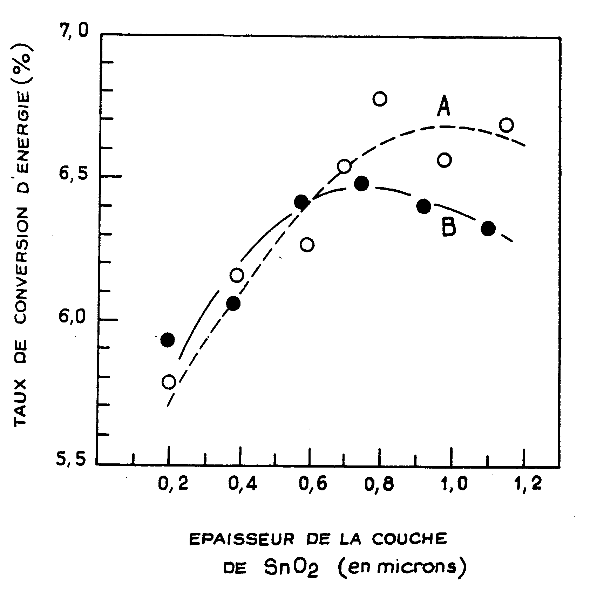

Un exemple de réalisation de l'invention sera maintenant décrit en détail en relation avec la figure unique jointe qui représente la variation du taux de conversion d'énergie de piles solaires à silicium amorphe utilisant des couches conductrices d'oxyde d'étain selon l'invention d'une part, classiques d'autre part, en fonction de l'épaisseur de ces couches.

Des piles solaires ont été réalisées d'une part à partir de substrats conducteurs selon l'invention, d'autre part à partir de substrats classiques et des comparaisons de performances ont été faites.

Pour réaliser ces piles solaires, on procède comme suit :

. on prépare des supports en verre sodo-calcique de 25 mm x 30 mm, de 1,1 mm d'épaisseur, on les lave, on les sèche et on les recouvre d'une couche de silice,

. ensuite, on les revêt d'une couche transparente à base d'oxyde d'étain pour obtenir le substrat selon l'invention, par la méthode C.V.D., en envoyant sur eux, lorsqu'ils sont chauffés à environ 550°C, un gaz constitué de vapeur de monobutyl trichlorure d'étain $(C_4H_9SnCl_3)$, de vapeur d'eau, d'oxygène et d'azote.

En faisant varier le temps de dépôt sur 7 supports en verre, on a obtenu 7 épaisseurs différentes de couche d'oxyde d'étain : 0.20 - 0.39 - 0.59 - 0.7 - 0.8 - 0.98 et 1.15 microns. Ces supports ainsi revêtus d'une couche selon l'invention sont appelés les substrats "A".

Pour faire des comparaisons, sur des supports en verre identiques, on dépose par C.V.D. des couches d'oxyde d'étain dopé au fluor en ajoutant au gaz utilisé pour réaliser les échantillons "A" un gaz fluoré : du 1.1-difluoroéthane.

En faisant varier les temps de dépôt, on obtient 6 substrats "B" ayant les épaisseurs de couche d'étain dopé au fluor suivantes : 0.19 - 0.37 - 0.57 - 0.75 - 0.92 et 1.10 microns. Avec ces substrats "A" et "B" on fabrique des piles solaires au silicium amorphe en procédant comme suit :

.   on dépose sur la couche d'oxyde d'étain une première épaisseur de silicium, semi-conducteur de type p, dopé au bore (a-SiC:H) de 0.015 micron d'épaisseur environ,

.   on dépose ensuite une seconde épaisseur de silicium, de semi-conducteur intrinsèque (a-Si:H) de 0,5 micron environ,

.   puis une troisième épaisseur dopée au phosphore, semi-conductrice de type n, Si($\mu$C-Si)-:H monocristalline de 0.05 micron environ. On utilise pour cela comme matière première un gaz de monosilane $SiH_4$ sous une pression d'environ 170 pa, distribué par un dispositif de décharge luminescente à haute fréquence de type à couplage capacitif,

.   ensuite on dépose les électrodes en aluminium (d'épaisseur environ 0.1 micron) par exemple par la méthode de vaporisation sous vide (vide de l'ordre de 10$^{-4}$ pa). Au moment de la réalisation de ces électrodes en aluminium, on pose un cache ayant des trous de 2 mm de diamètre et on fabrique ainsi des piles solaires de 2 mm de diamètre.

En exposant les piles solaires ainsi obtenues à une lumière de 100 mW/cm$^2$ d'AM1, on mesure le taux de conversion d'énergie et on utilise ces résultats pour construire les courbes de la figure jointe.

D'après cette figure, on remarque que lorsque l'épaisseur est supérieure à 0.7 micron, les piles fabriquées à partir des substrats "A" ont un meilleur taux de conversion de l'énergie que celles fabriquées à partir des substrats "B".

On peut admettre que la transmission lumineuse obtenue avec des couches à base d'oxyde d'étain résultant d'un composé contenant du chlore, mais absolument aucun autre halogène et en particulier pas de fluor, soit meilleure que pour des couches d'oxyde d'étain dopées au fluor. Même si la résistance électrique d'une telle couche non dopée est plus faible que celle d'une couche dopée au fluor, du fait de la meilleure transmission de la lumière visible, le taux de conversion photoélectrique est amélioré.

En outre pour des épaisseurs un peu élevées de la couche d'oxyde d'étain, supérieures à celles de l'ordre de 0.5 micron classiquement employées, et en particulier supérieures à 0.7 micron, la résistance électrique est un peu abaissée, du fait de l'épaisseur d'une part, et du fait que la taille des cristaux formés est augmentée, ce qui modifie de façon favorable l'état de surface de la couche, d'autre part.

## Revendications

**1.** Substrat conducteur et transparent pour élément photoélectrique, notamment d'une pile solaire, comprenant un support en particulier en verre, revêtu d'une couche conductrice transparente à base d'oxyde d'étain obtenue par décomposition thermique et oxydation, au contact du support porté à haute température, d'un composé de l'étain contenant du chlore sans autre halogène, caractérisée en ce qu'elle a une épaisseur d'au moins 0,7 micron ($\mu$m).

**2.** Substrat conducteur et transparent pour élément photoélectrique, notamment d'une pile solaire, comprenant un support en particulier en verre, revêtu d'une couche conductrice transparente à base d'oxyde d'étain, caractérisée en ce qu'elle est obtenue par décomposition thermique et oxydation, au contact du support porté à haute température, d'un composé de l'étain sans chlore mais associé à un autre composé contenant du chlore tel HCl et en ce qu'elle a une épaisseur d'au moins 0,7 micron ($\mu$m).

**3.** Substrat selon la revendication 1 ou la revendication 2, caractérisé en ce que la couche d'oxyde d'étain dont il est recouvert a une épaisseur de 0,8 à 1,2 microns ($\mu$m).

**4.** Substrat selon l'une des revendications 1 à 3, caractérisé en ce que le composé d'étain contenant du chlore est choisi dans le groupe comprenant le monobutyl trichlorure d'étain, le tétrachlorure d'étain, le diméthyl dichlorure d'étain.

**5.** Substrat selon l'une des revendications 2 ou 3, caractérisé en ce que le composé d'étain exempt de tout halogène est choisi parmi le groupe comprenant :
$(CH_{2n+1})_4$ Sn avec n = 1, 2, 3 ou 4
$(CH_3)_2$ SnH$_2$, $(C_4H_9)_3$ SnH
$(CH_4H_9)_2$ Sn $(COOCH_3)_2$.

**6.** Substrat conforme à l'une des revendications 1 à 5, caractérisé en ce que la couche conductrice est formée sur une couche de silice initialement formée sur le support.

7. Pile solaire au silicium amorphe, caractérisée en ce qu'elle possède un substrat transparent conducteur comprenant un support en verre revêtu d'une couche à base d'oxyde d'étain obtenue à partir d'un composé d'étain contenant du chlore à l'exception de tout autre halogène, d'une épaisseur au moins égale à 0,7 micron ($\mu$m).

8. Pile solaire selon la revendication 7, caractérisée en ce que le substrat à couche d'oxyde d'étain est recouvert d'épaisseurs de silicium amorphe et d'électrodes en aluminium.

## Claims

1. Conductive, transparent substrate for a photoelectric element, particularly a solar cell, comprising a support, more particularly of glass, coated with a transparent, conductive layer based on tin dioxide obtained by thermal decomposition and oxidation, in contact with the support raised to a high temperature, of a compound of tin containing chlorine, but without any other halogen, characterized in that it has a thickness of at least 0.7 micron ($\mu$m).

2. Conductive, transparent substrate for a photoelectric element, particularly a solar cell, comprising a support, more particularly of glass, coated with a transparent, conductive layer based on tin dioxide, characterized in that it is obtained by thermal decomposition and oxidation, in contact with the support raised to a high temperature, of a chlorine-free tin compound, which is associated with another compund containing chlorine, such as HCl and in that it has a thickness of at least 0.7 micron ($\mu$m).

3. Substrate according to claims 1 or 2, characterized in that the tin dioxide layer with which it is covered has a thickness of 0.8 to 1.2 microns ($\mu$m).

4. Substrate according to one of the claims 1 to 3, characterized in that the chlorine-containing tin compound is chosen from the group consisting of tin monobutyl trichloride, tin tetrachloride and tin dimethyl dichloride.

5. Substrate according to either of the claims 2 and 3, characterized in that the completely halogen-free tin compound is chosen from the group consisting of:

$(CH_{2n+1})_4$ Sn with n = 1, 2, 3 or 4
$(CH_3)_2$ $SnH_2$, $(C_4H_9)_3$ SnH
$(CH_4H_9)_2$ Sn $(COOCH_3)_2$.

6. Substrate according to any one of the claims 1 to 5, characterized in that the conductive layer is formed on a silica layer initially formed on the support.

7. Amorphous silicon solar cell, characterized in that it has a transparent, conductive substrate comprising a glass support coated with a tin dioxide-based layer obtained from a tin compound containing chlorine, with the exception of any other halogen, having a thickness of at least 0.7 micron ($\mu$m).

8. Solar cell according to claim 7, characterized in that the substrate with the tin dioxide layer is covered with thicknesses of amorphous silicon and aluminium electrodes.

## Patentansprüche

1. Leitendes und transparentes Substrat für ein photoelektrisches Element, insbesondere eine Solarzelle, welches einen Träger insbesondere aus Glas umfaßt, der mit einer leitenden transparenten Schicht auf Zinnoxidbasis, erhalten durch thermische Zersetzung und Oxidation, in Kontakt mit dem auf hohe Temperatur gebrachten Träger, einer Chlor ohne anderes Halogen enthaltenden Zinnverbindung, beschichtet ist, dadurch gekennzeichnet, daß sie eine Dicke von wenigstens 0,7 micron ($\mu$m) hat.

2. Leitendes und transparentes Substrat für ein photoelektrisches Element, insbesondere eine Solarzelle, welches einen Träger insbesondere aus Glas umfaßt, der mit einer leitenden transparenten Schicht auf Zinnoxidbasis beschichtet ist, dadurch gekennzeichnet, daß sie durch thermische Zersetzung und Oxidation, in Kontakt mit dem auf hohe Temperatur gebrachten Träger, einer Zinnverbindung ohne Chlor, jedoch in Verbindung mit einer anderen Chlor enthaltenden Verbindung, wie HCl, erhalten worden ist und daß sie eine Dicke von wenigstens 0,7 micron ($\mu$m) hat.

3. Substrat nach Anspruch 1 oder 2, dadurch gekennzeichnet, daß die Zinnoxidschicht, mit der es beschichtet ist, eine Dicke von 0,8 bis 1,2 micron ($\mu$m) hat.

4. Substrat nach einem der Ansprüche 1 bis 3, dadurch gekennzeichnet, daß die Chlor enthaltende Zinnverbindung aus der Monobutylzinntrichlorid, Zinntetrachlorid und Dimethylzinndichlorid umfassenden Gruppe ausgewählt ist.

5. Substrat nach einem der Ansprüche 2 oder 3, dadurch gekennzeichnet, daß die Zinnverbindung ohne jedes Chlor aus der aus

$(CH_{2n+1})_4 Sn$ mit n = 1, 2, 3 oder 4
$(CH_3)_2 SnH_2$, $(C_4 H_9)_3 SnH$
$(CH_4 H_9)_2 Sn (COOCH_3)_2$

umfassenden Gruppe ausgewählt ist.

6. Substrat nach einem der Ansprüche 1 bis 5, dadurch gekennzeichnet, daß die leitende Schicht auf einer anfangs auf dem Träger gebildeten Siliciumschicht ausgebildet ist.

7. Solarzelle mit amorphem Silicium, dadurch gekennzeichnet, daß sie ein transparentes leitendes Substrat besitzt, welches einen Träger aus Glas umfaßt, der mit einer Zinnoxidschicht, erhalten ausgehend von einer Chlor unter Ausschluß jeden anderen Halogens enthaltenden Zinnverbindung, in einer Dicke von wenigstens 0,7 micron (μm) beschichtet ist.

8. Solarzelle nach Anspruch 7, dadurch gekennzeichnet, daß das Substrat mit der Zinnoxidschicht mit einer amorphen Siliciumschicht und Aluminiumelektroden versehen ist.